# EUROPÄISCHE PATENTSCHRIFT

(11) **EP 1 271 105 B1**
(45) Veröffentlichungstag und Bekanntmachung des Hinweises auf die Patenterteilung: **08.10.2008**
(21) Anmeldenummer: 02010691.0
(22) Anmeldetag: 14.05.2002
(51) Int. Cl.: G01D 5/14

(54) **Vorrichtung zur Umwandlung der in einem Piezo-Sensor ausgelösten Messsignale in Digital-Signale**
Device for converting measurement signals produced by a piezo-sensor into digital signals
Dispositif pour convertir des signaux de mesure produits par un capteur piezo-électrique en signaux numériques

(30) Priorität: 28.06.2001 DE 10131284
(43) Veröffentlichungstag der Anmeldung: 02.01.2003
(73) Patentinhaber: Atlas Copco Construction Tools GmbH, 45143 Essen (DE)
(72) Erfinder: Hagemeister, Wilhelm, Dr.-Ing., 48301 Nottuln (DE); Deimel, Thomas, 45472 Mülheim (DE); Prokop, Heinz-Jürgen, Dr.-Ing., 40882 Ratingen (DE)
(74) Vertreter: Vomberg, Friedhelm

(56) Entgegenhaltungen:
- DE-A1- 19 923 680
- US-A- 4 507 653
- US-A- 5 372 046

## Beschreibung

Die Erfindung betrifft eine Umwandlungsvorrichtung für ein hydraulisches Schlagaggregat, insbesondere Hydraulikhammer, zur Umwandlung von Messsignalen, die durch während der Schlagvorgänge des Schlagaggregats auf einen Piezo-Sensor einwirkende Beschleunigungen in diesem ausgelöst werden und aus denen die Anzahl der in Schlagrichtung des Schlagaggregats ausgeführten Arbeitshübe ermittelt werden kann, in für die Verarbeitung in einem Mikroprozessor geeignete Digital-Signale.

Die Erfindung geht dabei - ebenso wie der aus der Druckschrift DE 199 23 680 A1 bekannte Lösungsvorschlag - von der Erkenntnis aus, dass die aktuelle Gesamtzahl der vom Schlagaggregat ausgeführten Schläge eine relevante Größe für die Ermittlung der aktiven Betriebsdauer darstellt, woraus - durch Vergleich mit entsprechenden Vorgaben - auch Aussagen über den Einsatz-Zustand des betreffenden Schlagaggregats abgeleitet werden können.
Eine Aussage über den Einsatz-Zustand des Schlagaggregats lässt sich im einfachsten Fall dadurch gewinnen, dass überprüft wird, ob die aktuelle Gesamtzahl der vom Schlagaggregat ausgeführten Schläge eine Größenordnung erreicht hat, welche der einen wartungsfreien Betriebszeitraum festlegenden Gesamt-Schlagzahl entspricht.

Mit der erwähnten Veröffentlichung ist bereits der Vorschlag unterbreitet worden, zur Ermittlung der Betriebsdauer und des Einsatz-Zustands eines hydraulischen Schlagaggregats während der einzelnen, zeitlich aufeinander folgenden Betriebsabschnitte des Schlagaggregats Messsignale zu erzeugen, aus denen die Anzahl der vom Schlagkolben des Schlagaggregats in einer Bewegungsrichtung ausgeführten Hübe ermittelt werden kann, die Anzahl der Signale fortlaufend aufzusummieren und als Gesamtzahl zu speichern sowie die jeweils aktuelle Gesamtzahl der Signale zumindest zeitweilig in Form einer auf den Einsatz-Zustand hinweisenden Anzeige erkennbar zu machen.

Zur Erzeugung der auf die Schlagzahl hinweisenden Messsignale kann dabei ein Messwertgeber in Form eines Piezo-Sensors eingesetzt werden, welcher aufgrund der Schlagkolben-Hübe ausgelöste Schwingungsvorgänge erfasst.

Der Erfindung liegt die Aufgabe zugrunde, eine Umwandlungsvorrichtung für ein hydraulisches Schlagaggregat, insbesondere Hydraulikhammer, zur Umwandlung mittels eines Piezo-Sensors erzeugter einschlägiger Messsignale in Digital-Signale anzugeben, welche - trotz der beim Einsatz hydraulischer Schlagaggregate zu erwartenden rauhen Arbeitsbedingungen - ausreichend zuverlässig die erforderlichen Informationen liefert und einen niedrigen Energiebedarf aufweist. Ferner soll die neuartige Umwandlungsvorrichtung derart ausgebildet sein, dass sie eine Kompaktbauweise zulässt und somit problemlos sowie ohne besonderen Aufwand dem Schlagaggregat an einer für die Erzeugung der Messsignale geeigneten Stelle zugeordnet werden kann.
Schließlich soll die Umwandlungsvorrichtung sich auch dadurch auszeichnen, dass sie weitgehend unabhängig ist von der Bauart, Baugröße und den sonstigen Kennzahlen des zu überwachenden Schlagaggregats.

Die Aufgabe wird durch eine Umwandlungsvorrichtung mit den Merkmalen des Anspruchs 1 gelöst. Der Grundgedanke der Erfindung besteht danach darin, die mittels eines Piezo-Sensors erzeugten Messsignale in mehreren aufeinander folgenden Stufen in Digital-Signale umzuformen, die eine ausreichend sichere Aussage über die vom Schlagaggregat ausgeführten Schlagvorgänge zulassen und eine für die Verarbeitung in einem Mikroprozessor geeignete Ausgestaltung einnehmen. Im Einzelnen weist die Umwandlungsvorrichtung folgende Merkmale auf:
einen mit dem Ausgang des Piezo-Sensors verbundenen Gleichrichter, unter dessen Einwirkung der Negativteil des mittels des Piezo-Sensors gewonnenen Messsignals unterdrückt wird;
einen sich an den Gleichrichter anschließenden Spitzenwert-Detektor, der den verbleibenden Positivteil des Messsignals in eine Hüllkurve umwandelt;
einen Hochpassfilter, unter dessen Einwirkung die Hüllkurven zeitlich aufeinanderfolgender Messsignale in Zwischensignale mit jeweils einen Nulldurchgang aufweisender Amplitude umgewandelt werden, und
einen dem Hochpassfilter nachgeschalteten sowie ausgangsseitig an den Digitaleingang des Mikroprozessors angeschlossenen Komparator, unter dessen Einwirkung die Zwischensignale in Digital-Signale mit rechteckförmigen Amplitudenverlauf umgewandelt werden.

Durch den Hochpassfilter wird die Lage der eingeleiteten Signale derart verändert, dass deren Amplitude jeweils einen einwandfreien Nulldurchgang aufweist. Demzufolge passt sich die Umwandlungsvorrichtung selbsttätig an das zugehörige Schlagaggregat an mit der Folge, dass die Umwandlungsvorrichtung ohne Umbau im Zusammenhang mit unterschiedlich ausgebildeten Schlagaggregaten eingesetzt werden kann.
Als Piezo-Sensor kann im Rahmen der Erfindung ein piezoelektrischer Schocksensor zur Anwendung kommen, wie er beispielsweise in einem Laptop zum Schutz der Festplatte eingesetzt wird.

Der Erfindungsgegenstand kann dadurch weitergehend ausgestaltet sein, dass der Komparator zusätzlich einen Kondensator aufweist und dieser derart ausgelegt ist, dass am Komparator-Ausgang lediglich Digital-Signale mit einem vorgegebenen zeitlichen Mindestabstand zum Digital-Signal des vorhergehenden Schlagvorgangs anliegen (Anspruch 2).
Der zusätzliche Kondensator stellt also sicher, dass etwa vom Piezo-Sensor zusätzlich erzeugte "Fehl-Signale" - die beispielsweise durch normalerweise nicht zu erwartende Beschleunigungen des Schlagaggregats ausgelöst werden - unterdrückt werden.

Vorzugsweise ist der Erfindungsgegenstand derart ausgebildet, dass der Piezo-Sensor gleichzeitig die Energiequelle für die dem Komparator vorgeschalteten Bestandteile - Gleichrichter, Spitzenwert-Detektor, Hochpassfilter - bildet und dass der Komparator an eine vom Piezo-Sensor unabhängige Energieversorgung angeschlossen ist (Anspruch 3).

Der Vorteil dieser Ausführungsform besteht somit darin, dass die Umwandlungsvorrichtung - mit Ausnahme des Komparators - keine äußere Energiezufuhr benötigt und lediglich einen niedrigen Energieverbrauch aufweist.

Dementsprechend ist es möglich, die Umwandlungsvorrichtung und den nachgeschalteten Mikroprozessor mit einer integrierten Batterieeinheit auszustatten, die unter Umständen eine Betriebsdauer von mehr als fünf Jahren ermöglicht.
Die Batterieeinheit kann dabei insbesondere aus einer oder mehreren Lithium-Thionyl-Chlorid-Batterien bestehen.

Die Handhabung und Wirtschaftlichkeit der Umwandlungsvorrichtung lassen sich dadurch verbessern, dass der Piezo-Sensor nebst Gleichrichter, Spitzenwert-Detektor, Hochpassfilter und Komparator mit dem Mikroprozessor zu einem eine mechanische Einheit bildenden Bauelement zusammengefasst ist, welches am Gehäuse des Schlagaggregats befestigbar ist (Anspruch 4).

Vorzugsweise sind die genannten Bestandteile - sowie die zuvor erwähnte Batterieeinheit und der ggf. dem Komparator zusätzlich zugeordnete Kondensator - über eine elastische Ausgussmasse innerhalb einer metallischen Hülse befestigt, die sich ihrerseits bei Befestigung an einem Schlagaggregat über eine elastische Dämpfungsschicht am Gehäuse des Schlagaggregats abstützt.

Die Ausgussmasse und die Dämpfungsschicht müssen dabei hinsichtlich ihres Schwingungsverhaltens derart ausgelegt sein, dass die vom Schlagaggregat ausgehenden Beschleunigungen im Piezo-Sensor mit ausreichender Sicherheit die erforderlichen Signale auslösen.

Im Normalfall ist es ausreichend, dass der Piezo-Sensor, Gleichrichter, Spitzenwert-Detektor, Hochpassfilter und Komparator derart ausgelegt und aufeinander abgestimmt sind, dass die vorgenannten Bestandteile bei Schlagfrequenzen des Schlagaggregats zwischen 3 und 70 Hz funktionsfähig sind (Anspruch 5).

Diese Ausgestaltung hat zur Folge, dass die Umwandlungsvorrichtung ohne weitergehende Anpassungsmaßnahmen weitgehend unabhängig ist von der Bauart, Baugröße und sonstigen Kennwerten des Schlagaggregats.

Die Erfindung wird nachfolgend anhand der Zeichnungen im Einzelnen erläutert.

Es zeigen:
- Fig. 1: schematisiert den grundsätzlichen Aufbau der neuen Umwandlungsvorrichtung nebst Mikroprozessor und Batterieeinheit im Zusammenwirken mit einem Hydraulikhammer;
- Fig. 2: ein Schaltschema der in Fig. 1 dargestellten Umwandlungsvorrichtung und
- Fig. 3a bis e: die in mehreren Stufen ablaufende Umwandlung des Messsignals in ein Digital-Signal mit rechteckförmigem Amplitudenverlauf.

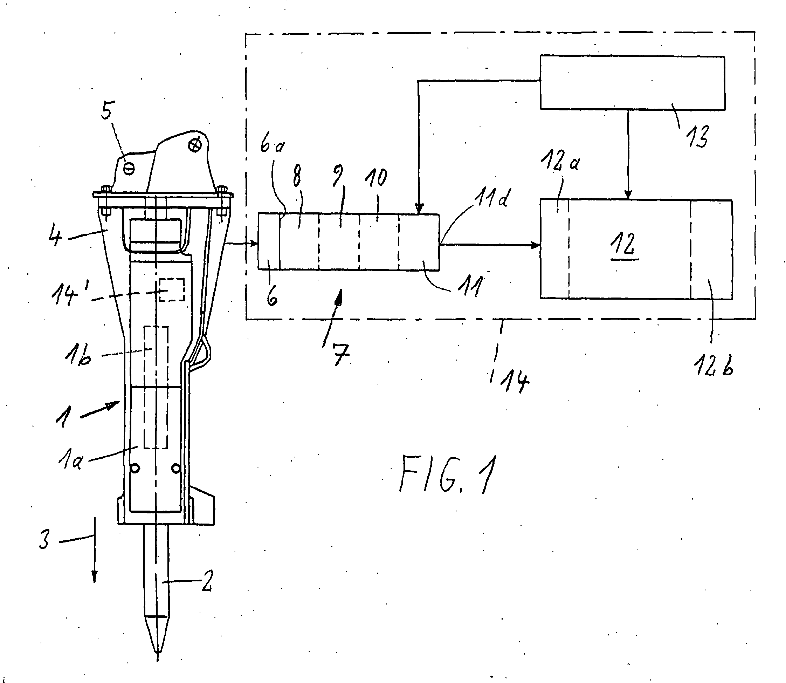

Die Darstellung gemäß Fig. 1 zeigt zunächst ein an sich bekanntes hydraulisches Schlagaggregat in Form eines Hydraulikhammers 1, in dessen Gehäuse 1a ein Schlagkolben 1 b in Längsrichtung hin und her beweglich geführt ist und unter Einwirkung einer nicht dargestellten Steuerung auf ein als Meißel 2 ausgebildetes Werkzeug einwirkt, wobei die vom Schlagkolben 1b ausgehende Bewegungsenergie in Schlagenergie umgesetzt wird.
Die Bewegung des Schlagkolbens 1b in Richtung des Arbeitshubs (Schlagrichtung) ist durch einen Pfeil 3 angedeutet.
Das Gehäuse 1a ist an einem Tragelement 4 - ausgebildet als Traggehäuse oder Tragrahmen - befestigt, wobei das Tragelement 4 eine Anschlusskonsole 5 aufweist. Über letztere kann das Tragelement 4 mit einem Trägergerät, insbesondere mit dem Ausleger eines Hydraulikbaggers, verbunden werden.

Das Trägergerät liefert - wie mit der Druckschrift 199 23 680 angegeben - auch die für den Betrieb des Hydraulikhammers 1 benötigte Hydraulikenergie.

Die im Betriebszustand des Hydraulikhammers 1, d. h. während der Schlagvorgänge des Schlagkolbens 1b, auftretenden Beschleunigungen wirken auch auf einen Piezo-Sensor 6 ein und lösen in diesem Messsignale aus, aus denen die Anzahl der in Schlagrichtung (Pfeil 3) des Hydraulikhammers 1 ausgeführten Arbeitshübe ermittelt werden kann.

Der Ausgang 6a des Piezo-Sensors 6 steht schaltungstechnisch mit einer Umwandlungsvorrichtung 7 in Verbindung, die als Hauptbestandteile einen Gleichrichter 8, einen Spitzenwert-Detektor 9, einen Hochpassfilter 10 und einen Komparator 11 aufweist.

Ausgangsseitig ist der Komparator 11 an den Digitaleingang 12a eines Mikroprozessors 12 angeschlossen, in dem die untere Einwirkung des Komparators 11 erzeugten Digital-Signale gespeichert und weitergehend verarbeitet werden.

Der Mikroprozessor 12 dient insbesondere dazu, die aufgenommenen Digital-Signale zu speichern, aufzusummieren und daraus Daten über die aktive Betriebsdauer des Hydraulikhammers 1 abzuleiten und - im Hinblick auf vorgegebene Wartungsintervalle - Informationen über den Einsatzzustand des Hydraulikhammers 1 bereitzustellen.

Die vom Mikroprozessor 12 insgesamt bereitgestellten Informationen können über eine Infrarot-Schnittstelle 12b drahtlos - beispielsweise über einen Laptop oder ein Mobiltelefon - ausgelesen werden. Die Infrarot-Schnittstelle 12b dient außerdem dazu, Daten, Programme und Befehle an den Mikroprozessor 12 zu übermitteln.
Für die Energieversorgung des Mikroprozessors 12 und des Komparators 11 ist eine Batterieeinheit 13 vorhanden, die zumindest eine Lithium-Thionyl-Chlorid-Batterie aufweist.

Zur Erhöhung der Betriebsdauer der Batterie 13 ist die Umwandlungsvorrichtung 7 derart ausgebildet, dass der Piezo-Sensor 6 gleichzeitig die Energiequelle für den Gleichrichter 8, den Spitzenwert-Detektor 9 und den Hochpassfilter 10 bildet; diese Bestandteile der Umwandlungsvorrichtung 7 sind also nicht auf eine äußere Energieversorgung angewiesen.

Wie in Fig. 1 durch eine strichpunktierte Rechteckfläche 14 angedeutet ist, sind die Bestandteile 6 bis 13 einschließlich zu einem eine mechanische Einheit bildenden Bauelement zusammengefasst, welches am Gehäuse 1 a des Hydraulikhammers 1 befestigt ist. Das mit der Rechteck-Umrandung 14 definierte Bauelement ist am Gehäuse 1a mit 14' bezeichnet. Abweichend davon kann das erwähnte Bauelement im Rahmen der Erfindung auch am Tragelement 4, an der Anschlusskonsole 5 oder am Traggerät - beispielsweise am Ausleger des Hydraulikbaggers - montiert sein.

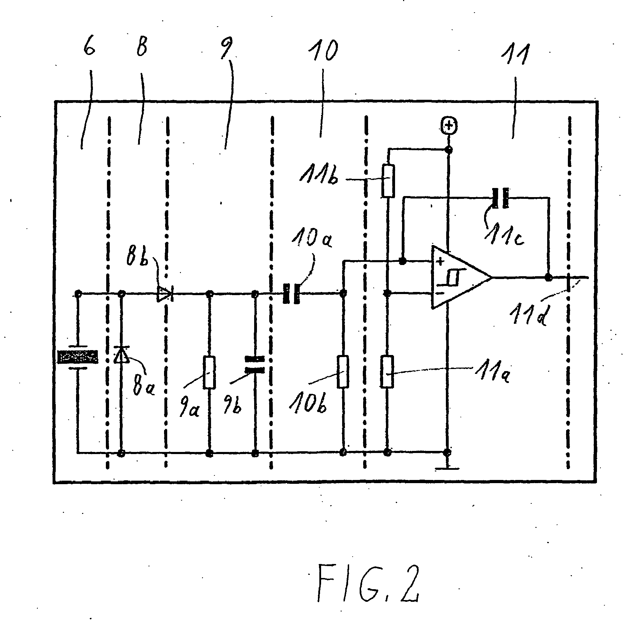

Dem Schemabild gemäß Fig. 2 sind die schaltungstechnische Verknüpfung der Bestandteile 6 und 8 bis 11 sowie der grundsätzliche Aufbau der Bestandteile 8 bis 11 zu entnehmen.

Danach ist der Piezo-Sensor 6 an den Gleichrichter 8 mit zwei Dioden 8a und 8b angeschlossen, wobei die Diode 8b auch einen Bestandteil des Spitzenwert-Detektors 9 darstellt. Der Piezo-Sensor 6 ist seinerseits mit dem Spitzenwert-Detektor 9 verknüpft, der einen hochohmigen Widerstand 9a und einen dazu parallelgeschalteten Kondensator 9b aufweist.
An den Bestandteil 9 schließt sich der Hochpassfilter 10 mit einem Kondensator 10a und einem hochohmigen Widerstand 10b an.
Dem Hochpassfilter 10 ist der Komparator 11 mit zwei hochohmigen Widerständen 11a und 11b nachgeschaltet, der mittels der Batterieeinheit 13 (vgl. dazu Fig. 1) mit Energie versorgt wird. Die Widerstände11a und 11 b erzeugen eine Referenzspannung, so dass die Umwandlungsvorrichtung gegen äußere Störspannungen unempfindlich ist. Zusätzlich ist der Komparator 11 mit einem Kondensator 11c ausgestattet; dieser dient zur Unterdrückung von Signalen, die einen vorgegebenen zeitlichen Mindestabstand zum Signal des vorhergehenden Schlagvorgangs unterschreiten. Wie bereits erwähnt, ist der Ausgang 11d des Komparators 11 mit dem Digital-Eingang 12a des Mikroprozessors 12 (vgl. dazu Fig. 1) verknüpft.
Der Piezo-Sensor 6, Gleichrichter 8, Spitzenwert-Detektor 9, Hochpassfilter 10 und Komparator 11 sind im übrigen derart ausgelegt und aufeinander abgestimmt, dass die aus den Bestandteilen 8 bis 11 gebildete Umwandlungsvorrichtung 7 für Schlagfrequenzen des Hydraulikhammers 1 zwischen 3 und 70 Hz eingesetzt werden kann.

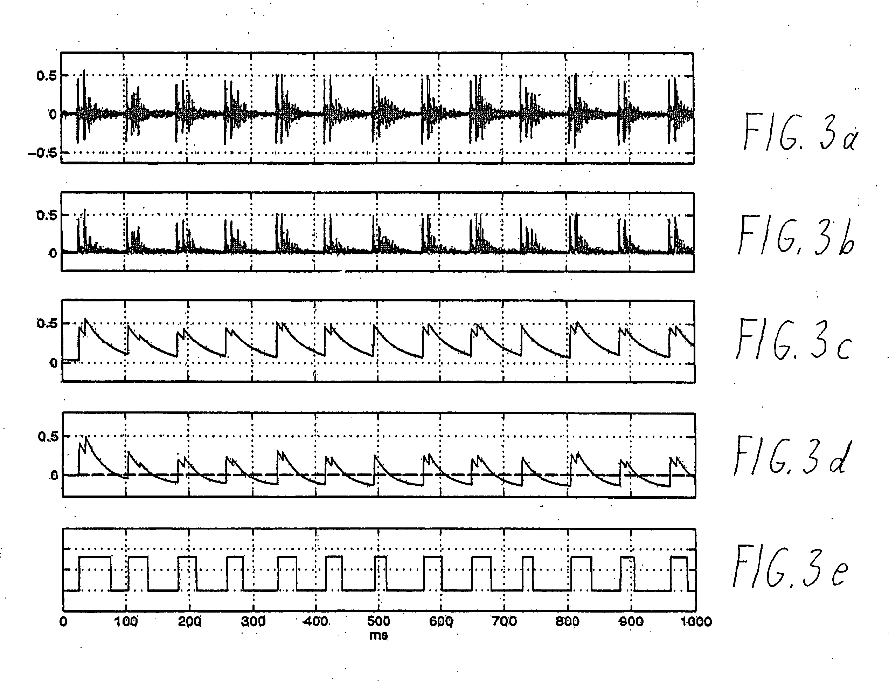

Die Wirkungsweise des Piezo-Sensors 6 und der Bestandteile 8 bis 11 der Umwandlungsvorrichtung 7 werden nachfolgend anhand der Fig. 3a bis 3e erläutert. Dabei ist jeweils der Amplitudenverlauf der betreffenden Signale über der Zeit (in Millisekunden) aufgetragen.

Die aufgrund der Schlagvorgänge des Hydraulikhammers 1 auftretenden und auch auf den Piezo-Sensor 6 einwirkenden Beschleunigungen lösen in dem Piezo-Sensor die Erzeugung der in Fig. 3a dargestellten Messsignale aus. Diese werden gemäß Fig. 3b unter Einwirkung des Gleichrichters 8 derart beeinflusst, dass der Negativteil des dem Gleichrichter 8 zugeführten Messsignals unterdrückt (d. h. abgeschnitten) wird. Mittels des Spitzenwert-Detektors 9 wird der verbleibende Positivteil des Messsignals in eine Hüllkurve umgewandelt (Fig. 3c). Diese Hüllkurve wird unter Einwirkung des Hochpassfilters (wie Fig. 3d erkennen lässt) derart verschoben, dass der Amplitudenverlauf zeitlich aufeinanderfolgender Zwischensignale jeweils "saubere" Nulldurchgänge aufweist.
Die in dieser Weise aufbereiteten Zwischensignale werden mittels des Komparators 11 in Digital-Signale mit rechteckförmigem Amplitudenverlauf umgewandelt, so dass sie von dem nachgeschalteten Mikroprozessor 12 aufgenommen und verarbeitet werden können.

Die zuvor beschriebene Ausgestaltung und schaltungstechnische Verknüpfung der Bestandteile 6 und 8 bis 11 ermöglicht es zum einen, die Umwandlungsvorrichtung 7 ohne Umbaumaßnahmen im Zusammenhang mit unterschiedlich ausgebildeten hydraulischen Schlagwerken einzusetzen. Zum anderen kann durch geeignete Auslegung der Bestandteile 6 und 8 bis 10 erreicht werden, dass die Umwandlungsvorrichtung 7 - mit Ausnahme des Komparators 11 - keine zusätzliche Energiequelle benötigt.
Die Erfindung trägt also dazu bei, die bereits mit der Druckschrift DE 199 23 680 beschriebene Bereitstellung von Informationen zu erleichtern bzw. in wirtschaftlicher Hinsicht zu verbessern, aus denen eine Aussage über die aktive Betriebsdauer eines hydraulischen Schlagaggregats und dessen Einsatzzustand - beispielsweise im Hinblick auf vorgegebene Wartungsintervalle - abgeleitet werden kann.

## Patentansprüche

1. Umwandlungsvorrichtung für ein hydraulisches Schlagaggregat, insbesondere Hydraulikhammer, zur Umwandlung von Messsignalen, die durch während der Schlagvorgänge des Schlagaggregats (1) auf einen Piezo-Sensor (6) einwirkende Beschleunigungen in diesem ausgelöst werden und aus denen die Anzahl der in Schlagrichtung (Pfeil 3) des Schlagaggregats (1) ausgeführten Arbeitshübe ermittelt werden kann, in für die Verarbeitung in einem Mikroprozessor (12) geeignete Digital-Signale, **gekennzeichnet durch** folgende Merkmale:
einen mit dem Ausgang (6a) des Piezo-Sensors (6) verbundenen Gleichrichter (8), unter dessen Einwirkung der Negativteil des Messsignals unterdrückt wird;
einen sich an den Gleichrichter (8) anschließenden Spitzenwert-Detektor (9), der den verbleibenden Positivteil des Messsignals in eine Hüllkurve umwandelt;
einen Hochpassfilter (10), unter dessen Einwirkung die Hüllkurven zeitlich aufeinander folgender Messsignale in Zwischensignale mit jeweils einen Nulldurchgang aufweisender Amplitude umgewandelt werden, und einen dem Hochpassfilter (10) nachgeschalteten sowie ausgangsseitig an den Digital-Eingang (12a) des Mikroprozessors (12) angeschlossenen Komparator (11), unter dessen Einwirkung die Zwischensignale in Digital-Signale mit rechteckförmigem Amplitudenverlauf umgewandelt werden.

2. Umwandlungsvorrichtung nach Anspruch 1, **dadurch gekennzeichnet, dass** der Komparator (11) zusätzlich mit einem Kondensator (11c) ausgestattet und dieser derart ausgelegt ist, dass am Komparator-Ausgang (11d) lediglich Digital-Signale mit einem vorgegebenen zeitlichen Mindestabstand zum Digital-Signal des vorhergehenden Schlagvorgangs anliegen.

3. Umwandlungsvorrichtung nach Anspruch 1 oder 2, **dadurch gekennzeichnet, dass** der Piezo-Sensor (6) gleichzeitig die Energiequelle für die dem Komparator (11) vorgeschalteten Bestandteile - Gleichrichter (8), Spitzenwert-Detektor (9), Hochpassfilter (10) - bildet und dass der Komparator (11) an eine vom Piezo-Sensor (6) unabhängige Energieversorgung (13) angeschlossen ist.

4. Umwandlungsvorrichtung nach einem der vorhergehenden Ansprüche, **dadurch gekennzeichnet, dass** der Piezo-Sensor (6) nebst Gleichrichter (8), Spitzenwert-Detektor (9), Hochpassfilter (10) und Komparator (11) mit dem Mikroprozessor (12) zu einem eine mechanische Einheit bildenden Bauelement (14') zusammengefasst ist, welches am Gehäuse (1 a) des Schlagaggregats (1) befestigbar ist.

5. Umwandlungsvorrichtung nach einem der vorhergehenden Ansprüche, **dadurch gekennzeichnet, dass** der Piezo-Sensor (6), Gleichrichter (8), Spitzenwert-Detektor (9), Hochpassfilter (10) und Komparator (11) derart ausgelegt und aufeinander abgestimmt sind, dass die vorgenannten Bestandteile bei Schlagfrequenzen des Schlagaggregats (1) zwischen 3 und 70 Hz funktionsfähig sind.

## Claims

1. Converting device for a hydraulic percussion device, in particular hydraulic hammer, for converting measurement signals into digital signals, with the measurement signals having been initiated in a piezo sensor (6) by accelerations acting on the sensor during the impacts of a percussion device (1) and being used to determine the number of work strokes that have been executed in the impact direction (arrow 3) of the percussion device with the digital signals being suitable for processing in a microprocessor, **characterised by** the following features:
a rectifier that is connected to the output (6a) of the piezo sensor (6) and suppresses the negative component of a measurement signal;
a peak-value detector (9) connected to the rectifier (8) and converting a remaining, positive component of the measurement signal into an envelope curve;
a high-pass filter (10) connected to receive the envelope curve and causing the envelope curves of consecutive measurement signals to be converted into intermediate signals whose amplitude has a respective zero passage; and
a comparator (11), whose input is connected to the output of the high-pass filter (10) and whose output is connected to a digital input (12a) of the microprocessor (12), for converting the intermediate signals into digital signals having a rectangular amplitude.

2. Converting device according to claim 1, **characterised in that** the comparator (11) is provided additionally with a capacitor (11c) dimensioned such that there are at the comparator output (11d) only digital signals with a predetermined minimum interval from the digital signal of the preceding impact.

3. Converting device according to claim 1 or 2, **characterised in that** the piezo sensor (6) simultaneously constitutes the energy source for the rectifier (8), he peak-value detector (9) and the high-pass filter (10), which are all disposed upstream of the comparator (11); and that the comparator (11) is connected to an energy supply (13) that is independent of the piezo sensor (6).

4. Converting device according to one of the preceding claims, **characterised in that** the piezo sensor (6), the rectifier (8), the peak-value detector (9), the high-pass filter (10) and the comparator (111) are combined with the microprocessor (12) into a component (14') that forms a single mechanical unit that is mountable to a housing (1a) of the percussion device.

5. Converting device according to one of the preceding claims, **characterised in that** the piezo sensor (6), the rectifier (8), the peak-value detector (9), the high-pass filter (10) and the comparator (11) are designed and matched to one another such that the said component parts are capable of functioning at impact frequencies of the percussion device (1) between 3 and 70 Hz.

## Revendications

1. Dispositif convertisseur pour une unité hydraulique à percussion, en particulier un marteau hydraulique, destiné à convertir des signaux de mesure - lesquels sont déclenchés dans un capteur piézo-électrique (6) par des accélérations agissant sur ce dernier durant les opérations de percussion dé ladite unité à percussion (1) et à partir desquels peut être déterminé le nombre des courses de travail exercées dans le sens de percussion (flèche 3) de l'unité à percussion (1) - en signaux numériques se prêtant à être traités dans un microprocesseur (12), **caractérisé par** les caractéristiques suivantes :
un redresseur (8) qui est relié à la sortie (6a) du capteur piézo-électrique (6) et sous l'effet duquel la partie négative du signal de mesure est supprimée ;
un détecteur de valeur de crête (9) qui est monté à la suite du redresseur (8) et qui convertit la partie positive restante du signal de mesure en une enveloppante ;
un filtre passe-haut (10) sous l'effet duquel les enveloppantes de signaux de mesure successifs sont transformées en signaux intermédiaires avec respectivement une amplitude présentant un passage par zéro, et
un comparateur (11) qui est intercalé à la suite du filtre passe-haut (10) et raccordé du côté de la sortie à l'entrée numérique (12a) du microprocesseur (12) et sous l'effet duquel les signaux intermédiaires sont transformés en signaux numériques ayant une caractéristique rectangulaire d'amplitude.

2. Dispositif convertisseur selon la revendication 1, **caractérisé par le fait que** ledit comparateur (11) est équipé en sus d'un condensateur (11c) et que celui-ci est conçu de telle façon que les signaux appliqués à la sortie (11d) du comparateur soient uniquement des signaux numériques avec un intervalle minimal prédéterminé par rapport au signal numérique de l'opération précédente de percussion.

3. Dispositif convertisseur selon la revendication 1 ou 2, **caractérisé par le fait que** ledit capteur piézo-électrique (6) constitue en même temps la source d'énergie pour les composants placés en amont du comparateur (11) - donc le redresseur (8), le détecteur de valeur de crête (9), le filtre passe-haut (10) - et que ledit comparateur (11) est connecté à une alimentation d'énergie (13) indépendante du capteur piézo-électrique (6).

4. Dispositif convertisseur selon l'une des revendications précédentes, **caractérisé par le fait que** le capteur piézo-électrique (6) outre le redresseur (8), le détecteur de valeur de crête (9), le filtre passe-haut (10) et le comparateur (11) est réuni avec le microprocesseur (12) pour constituer un élément (14') formant une unité mécanique qui peut être fixé sur le carter (1a) de l'unité à percussion (1).

5. Dispositif convertisseur selon l'une des revendications précédentes, **caractérisé par le fait que** ledit capteur piézo-électrique (6), le redresseur (8), le détecteur de valeur de crête (9), le filtre passe-haut (10) et le comparateur (11) sont conçus et accordés les uns aux autres de manière à ce que les composants susmentionnés soient aptes à fonctionner à des fréquences de percussion de l'unité à percussion (1) comprises entre 3 et 70 Hz.
